Europäisches Patentamt

European Patent Office

Office européen des brevets

(11) Publication number: **0 343 738**
**A2**

## (12) EUROPEAN PATENT APPLICATION

(21) Application number: **89201296.4**

(22) Date of filing: **22.05.89**

(51) Int. Cl.⁴: **H01L 21/86 , H01L 21/365 , H01L 31/18**

(30) Priority: **27.05.88 GB 8812591**

(43) Date of publication of application:
**29.11.89 Bulletin 89/48**

(84) Designated Contracting States:
**DE FR GB IT**

(71) Applicant: **PHILIPS ELECTRONIC AND ASSOCIATED INDUSTRIES LIMITED**
**Philips House 188 Tottenham Court Road London W1P 9LE(GB)**

(84) **GB**

Applicant: **N.V. Philips' Gloeilampenfabrieken Groenewoudseweg 1 NL-5621 BA Eindhoven(NL)**

(84) **DE FR IT**

(72) Inventor: **Ard, Christopher Kyle c/o PHILIPS COMPONENTS**
**2ND Avenue Millbrook Industrial Estate Southampton Hampshire S09 7BH(GB)**

(74) Representative: **Stevens, Brian Thomas et al PHILIPS ELECTRONICS Patents and Trade Marks Department Centre Point New Oxford Street London WC1A 1QJ(GB)**

(54) **Manufacture of electronic devices comprising cadmium mercury telluride with silicon-on-sapphire circuitry.**

(57) The benefits of silicon-on-sapphire (SOS) circuitry are combined with the growth of crystalline cadmium mercury telluride (CMT) in electronic devices, for example to provide fast signal processing circuits for CMT infrared detectors. A first mask is applied to a silicon layer on a sapphire base except at a window which includes a desired site for a CMT device. After etching through the silicon to the sapphire in the window CMT is grown overall. A second mask is then applied at the desired site only and the CMT etched away except where protected by the second mask which is then removed to reveal CMT grown on the sapphire at the desired site. The SOS circuitry is provided in the silicon layer before the first mask is applied, which is only removed once the CMT processing is complete to allow metal connections between the SOS circuitry and the CMT device to be made.

# MANUFACTURE OF ELECTRONIC COMPRISING CADMIUM MERCURY TELLURIDE WITH SILICON-ON-SAPPHIRE CIRCUITRY.

This invention relates to electronic devices comprising crystalline cadmium mercury telluride (CMT) and to methods of manufacture in which the CMT is grown on a substrate by deposition from a vapour phase. The electronic devices may be, for example, photoconductive infrared detectors, photodiode infrared detectors, and bipolar transistors.

Published British Patent Application GB-A-2 146 663 discloses a method of depositing CMT on various substrates by metal organic vapour phase epitaxy (MOVPE). British Patent Application 8705468 (PHB 33343), subsequently published as GB-A-2 202 236, discloses a method of flash cleaning a substrate prior to CMT deposition from a vapour phase. The whole contents of GB-A-2 146 663 and GB-A-2 202 236 are hereby incorporated herein as reference material.

A particular application of CMT is to arrays of infrared detectors, possibly two dimensional arrays, for use in thermal imagers. In this case it is desirable to have electronic circuits adjacent to the detectors in the plane of the array to sample the detector outputs in sequence to pass them to an array output for subsequent use in reconstructing a visible version of the thermal image incident on the array. MOS circuitry in silicon near each detector would be suitable. If the CMT detectors were grown on a silicon substrate, the MOS circuits could be provided directly on the substrate, for example as illustrated in Figures 5 to 7 of GB-A-2 202 236. However, it is desirable that the CMT should be grown as an epitaxial crystalline layer, and the lattice match between CMT and silicon is not as good as could be desired; it is also not very easy to clean the silicon surface prior to CMT growth. Finally, silicon as a substrate does not provide a radiation-hard array as may be desired in a thermal imager intended for military use.

According to a first aspect of the invention there is provided a method of manufacturing an electronic device comprising crystalline cadmium mercury telluride which is grown on a substrate by deposition from a vapour phase, characterised in that the substrate comprises a silicon layer upon a sapphire base and in that the method comprises the steps of applying over the silicon layer a first mask having a window which includes the desired site of the cadmium mercury telluride device, etching through the silicon layer at the window to expose the sapphire base, growing at least one layer of the cadmium mercuy telluride over the substrate, applying a second mask over the cadmium mercury telluride at the desired site, etching away the cadmium mercury telluride except at the desired site where protected by the second mask, exposing at least part of the cadmium mercury telluride grown on the sapphire base at the desired site, and providing at least one electrically conducting connecting to the exposed cadmium mercury telluride.

Various benefits of silicon-on-sapphire (SOS) circuitry and a reference bibliography are set out in an article by R. S. Ronen and F. B. Micheletti in Solid State Technology, August 1975, pages 39 to 46, the whole contents of which is hereby incorporated herein as reference material.

A principal advantage of SOS circuitry is its inherent dielectric isolation, both d.c. and a.c. An absence of silicon, except in the active device areas, significantly reduces parasitic capacitance between lines and essentially eliminates the parasitic capacitance to the substrate. The absence of silicon between device/circuit areas is used in accordance with the present invention for CMT epitaxy on the sapphire. Formation of device electrodes by doping through the silicon layer to the sapphire reduces electrode capacitance by several orders of magnitude because of the reduction in junction areas. This significant reduction in electrode and inter-electrode capacitance enables many circuit elements to achieve their maximum bandwidth and frequency response in SOS circuits, and this electrode structure can facilitate interconnections to laterally adjacent CMT devices formed in accordance with the present invention.

Other advantages inherent in SOS/MOS technology are a significantly reduced area of the elements and circuits because of the simple dielectric isolation. In general the SOS/MOS process is very simple. For some circuits it requires fewer mask levels than does a comparable bulk process. With all the above advantages combined in specific circuits (e.g. CMOS), SOS/MOS technology may be competitive in prices with bulk silicon technology. Moreover, in switching and memory applications where very low standby-power and very high speed are simultaneously sought, SOS technology is an interesting approach.

The present inventor has concluded that these advantages of SOS are particularly applicable in the case of arrays of cooled infrared detectors where very low power consumption in the circuitry associated with each detector is desired to reduce the load on the cooling system to the minimum. It is also relatively easy to grow crystalline epitaxial CMT on sapphire (rather than on silicon), and good enough quality crystalline CMT can be grown on a sapphire surface re-exposed by etching away the silicon circuit layer. Additionally, SOS/MOS technology has the potential to provide radiation-hard devices by enabling circuits to be provided on a plurality of electrically isolated islands.

Thus the CMT can be good crystalline quality at least where grown on the sapphire base at the window, while a layer of silicon is present immediately adjacent which may accommodate SOS circuitry for use with the CMT device. It is often desirable to use higher process temperatures in the formation of the silicon circuitry than would be acceptable in the formation of the CMT device. Accordingly, the method will usually preferably be characterised by the steps of constructing an electronic circuit on the silicon layer before the first mask is applied, exposing a connection area of the circuit by removing at least part of the first mask after growing and etching the cadmium mercury telluride, and then providing a conducting connection or connections between the exposed cadmium mercuy telluride and the exposed connection area of the electronic circuit. The first mask may be, for example, a sputtered layer of silicon dioxide and will protect the electronic circuit during the subsequent process steps which occur before this first mask is finally removed preparatory to making the conducting connection. Depending on the materials used, part of the first and/or second mask may be retained in the manufactured device as an insulating and/or passivating layer or as an electrode. Alternatively the first and/or second mask may be removed entirely.

To improve the degree of crystalline epitaxy obtained in the CMT, the method of the invention may be further characterised in that, after exposing the sapphire base in the window but before growing the cadmium mercury telluride, a buffer layer of cadmium telluride is grown over the substrate. The method may be yet further characterised in that a lower cadmium mercury telluride layer is selectively retained in an area where an upper layer of cadmium mercuy telluride is etched away, and is metallised in that area to form a second conducting connection to the cadmium mercury telluride device.

According to a second aspect of the invention there is provided an electronic device comprising crystalline cadmium mercury telluride grown on a substrate, characterised in that the substrate comprises a silicon layer upon part of a sapphire base, in that the cadmium mercury telluride is deposited on the sapphire base in a window in the silicon layer, and in that an electrically conducting connection is present from an area of the silicon layer to the cadmium mercury telluride device. Usually an electronic circuit is provided on the silicon layer, and at least one conducting connection is provided between the cadmium mercury telluride and the electronic circuit. For improved epitaxy between the grown CMT and the sapphire base, the device may be characterised in that a buffer layer of cadmium telluride is provided between the sapphire base and the cadmium mercury telluride in the window.

The benefits of the invention are particularly evident in a device comprising on the sapphire base a linear array of cadmium mercury telluride infrared detectors connected one each to a linear array of electronic circuits. The invention permits close packing of a row of the detectors and also of a row of the associated circuits which (being SOS circuitry) can each be small in area relative to the associated detector, and individual connections between the CMT devices and SOS circuits can be formed simply by metallisation patterns between facing areas of each at intervals along one side of the row. Indeed, the device may comprise a two-dimensional array of cadmium mercury telluride infrared detectors arranged in rows which alternate with rows of circuits, the circuits of each circuit row being connected one each with a detector in an adjacent detector row.

Such array devices may comprise, for example, a lower cadmium mercury telluride layer which also extends between adjacent detectors and which is metallised at least in one area to provide a common connection to the detectors.

Embodiments of the invention will now be described, by way of example, with reference to the accompanying schematic drawings in which

Figures 1 to 10 inclusive are cross-sectional views at different stages of method of constructing a CMT device,

Figure 11 shows a perspective view of the finished device,

Figure 12 is a plan view of part of a linear array of CMT infrared detectors constructed in accordance with the invention, and

Figure 13 is a plan view of a two-dimensional array of CMT infrared detectors constructed in accordance with the invention.

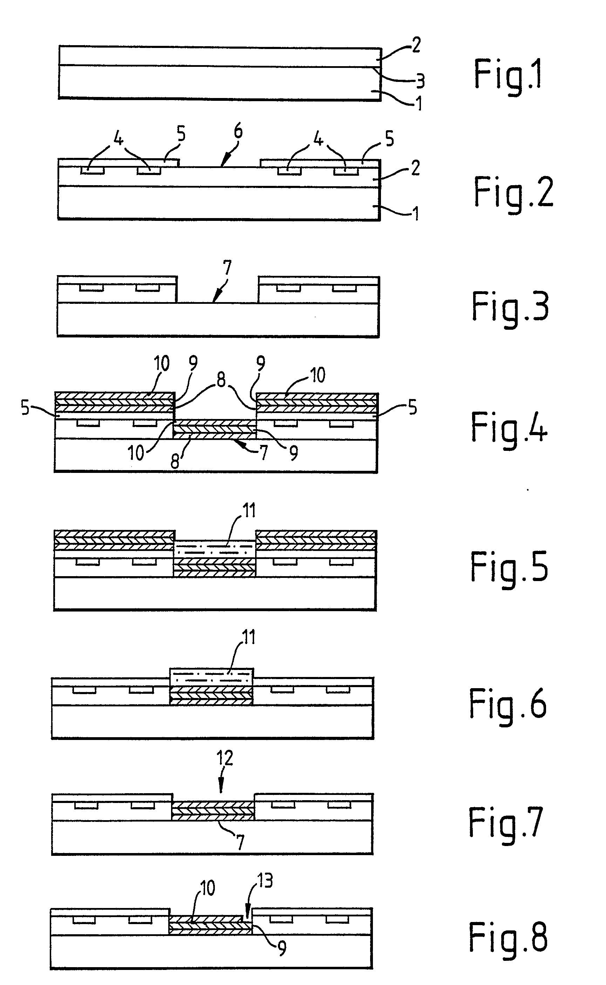

Referring to Figure 1 a section of a sapphire base 1 is shown, the sapphire being an artificial crystal of aluminium oxide, $Al_2O_3$, grown by methods well known in the art. The hexagonal sapphire crystal is cut in relation to its crystallographic axes so as to expose a basal plane face on its upper surface 3. This provides a sufficiently good lattice match for the epitaxially grown silicon crystal layer 2. The silicon is grown to a suitable thickness, for example 10 to 15 microns, by vapour phase epitaxy, VPE, from silane gas, $SiH_4$, at a temperature in the region of 1,025 degrees Celsius by methods well known in the art of silicon-on-sapphire, SOS, technology.

Figure 2 shows, very schematically, electronic circuits 4 constructed in the silicon layer the circuit elements of which may be formed in known manner in CMOS technology, for example. The silicon layer may be patterned into active device/circuits islands in known manner. A first mask 5, which may be of sputtered silicon dioxide, is then applied to the silicon circuit layer except at a window 6 at the desired site of the CMT electronic device. This mask protects the electronic circuits during the following process steps.

Figure 3 shows the result of the next step of the method in which the silicon is etched away in the window 6 down to and exposing the sapphire surface 7. A suitable etchant is potassium hydroxide. Alternatively, plasma etching may be used.

Figure 4 shows the effect of the next step in which the cadmium mercury telluride, CMT, to comprise the device is grown over the whole substrate, on the surface 7 and on the first mask 5. The CMT is grown by metal-organic vapour phase epitaxy, (MOVPE), first cleaning the sapphire surface 7 by baking in hydrogen at 700 to 1,000 degrees Celsius. In this example a cadmium telluride, CdTe, buffer layer 8, a cubic structure, is first grown on the substrate to a depth of 1 to 5 microns to provide a better lattice match to the hexagonal sapphire and, later, to the CMT. Suitable alkyls for MOVPE may be dimethyl cadmium (DMC) and diethyl tellurium (DET) or di-isopropyl tellurium (DIPT). The MOVPE process is well known in this art and will not be described further. In this example, two layers 9,10 of CMT are then grown on the CdTe layer, also by MOVPE, but this time including the vapour of mercury in the process. One process for growing CMT is known as the interdiffusion multilayer process (IMP) and is described in GB-A-2 146 663. In this process, alternate very thin, i.e. submicron, layers of cadmium telluride and mercury telluride are grown, interdiffusion occuring during growth to give a single layer of CMT, the relative layer thicknesses giving the relative proportions of cadmium and mercury in the CMT. Alternatively, the CMT may be grown by a ternary method, alkyls of cadmium and tellurium being always present simultaneously with mercury vapour.

In the present example the electronic device is a CMT photodiode intended for use as a detector of thermal infrared radiation. Thus the two layers 9,10 of CMT form a p-n junction. Each layer is grown with a different added dopant and under different conditions to obtain the desired conduction type and concentration in the layer. The dopant gas may be phosphine or arsine to add phosphorus or arsenic respectively to realise a p-type layer or a gallium alkyl, such as trimethyl gallium (TMG) or trimethyl aluminium (TMAL) to realize an n-type layer. Each CMT layer may be about 5 microns thick in this example.

Alternatively, instead of forming the p-n junction by epitaxial growth of CMT 9,10 of opposite conductivity types, the epitaxially grown CMT material may be of one conductivity type (p type) and the region of opposite conductivity type can be formed by diffusion or implantation in known manner into this epitaxial material thereby providing the p-n junction.

In the next step, Figure 5, a second mask 11 comprising a resist is applied to the CMT in the window area. Extraneous CMT is then removed (Figure 6) with an etch, such as bromine in methyl alcohol, and then the resist is removed to expose the CMT 12 on the surface 7 in the window 6 (Figure 7).

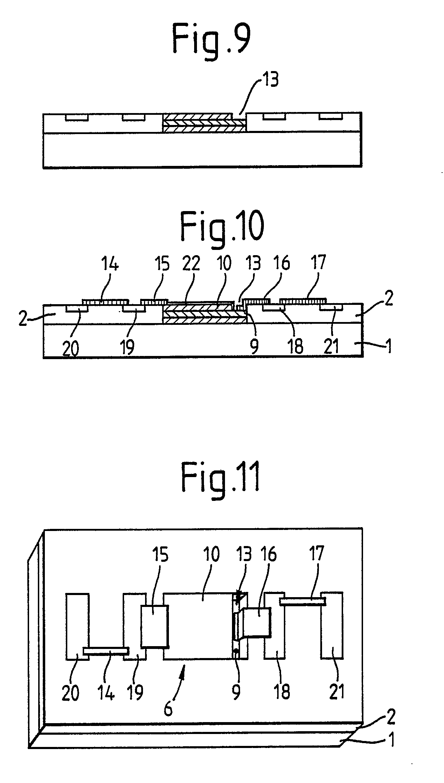

In a further mask and etch process, a contact opening 13 is made at one side in the upper layer 10 of CMT down to the lower layer 9 of CMT (Figure 8). The first mask of SiO₂ is now removed by etching with hydrofluoric acid (Figure 9). Metal conducting connections 14 to 17 inclusive are then evaporated onto the device through a suitable mask (Figure 10). Connection 16 makes contact between the lower CMT layer 9 (via opening 13) and a connection area of circuit 18, and connection 15 makes contact between the upper CMT layer 10 and a connection area of circuit 19. Connections 14 and 17 are shown schematically, connecting areas of circuits 20 and 19, and 18 and 21 respectively. With these final connections made, the upper surface of the CMT is passivated 22 by known methods, for example with zinc sulphide.

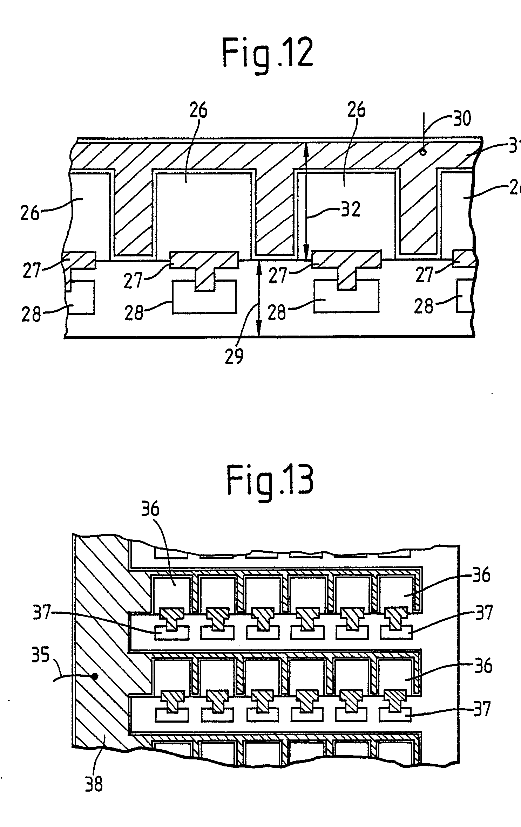

Figure 11 shows a plan perspective view of the resulting infrared detector device, the various parts being numbered to correspond with those in Figure 10. The two connections 15 and 16 make connection with the p and n type CMT layers respectively of the photodiode, the receptive area of which fills the bulk of the area of the window 6.

The circuits 18,21 and 20,19 are shown in pairs on common silicon layers 2. But it should be noted that the masking procedure can be arranged to produce each circuit on an isolated silicon island as may be required in a radiation hard device.

The photodiode junction may be a homojunction, and p and n layers having the same proportions of cadmium to mercury. However, heterojunctions may be provided such as $\overline{p}$-n of $\overline{n}$-p having different composition layers. More complex multilayer structures may be provided in the device window. Alternatively the electronic device may be a photoconductive CMT infrared detector. In this case the CMT would be undoped n-type CMT which would be annealed in mercury vapour after deposition on the sapphire to fill in the mercury vacancies and reveal the background donor concentration.

The invention may be applied to arrays of CMT devices such as arrays of CMT infrared detectors. Figure 12 shows a part of a linear array of CMT p-n junction photodiode detectors 26 and a silicon circuit layer (provided as a strip of width 29) on a sapphire substrate. The upper CMT layer of each detector is connected to an associated circuit 28 by metallisation 27 at one side of the row. The lower CMT layer of each detector is connected to a common connection 30 via metallisation 31. In this case a common connection is formed to the lower CMT layer as follows. After the stage indicated by Figure 5 when the CMT elements 26 have been masked, a selective etch is made down to but not removing the lower CMT layer 9. Another mask is then applied to the remainder of a strip of width 32 and etching is then continued to remove the CMT and CdTe from the strip 29, that is, from the silicon. This returns the device to the condition of Figure 6 except that the CMT/CdTe layers now extend all over the strip 32 and are suitably masked until the metallisation stage at which metallisations 27 and 31 are provided simultaneously.

Figure 13 show the "row" approach of Figure 12 applied to providing a two-dimensional array of CMT infrared detectors 36 associated one each with electronic circuits. The metallisation 38 provided on the CdTe layer now provides a common connection 35 to all rows of detectors of the array. The relative sizes of detectors and circuits have been roughly equalised, for clarity only. In practice the rows of circuits would be much smaller in width than the rows of detectors so that most of the detector array area would be occupied by infrared sensitive CMT surface.

From reading the present disclosure, other modifications will be apparent to persons skilled in the art. Such modifications may involve other features which are already known in the design, manufacture and use of SOS and other silicon circuits, CMT devices and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention. The applicant hereby give notice that new claims may be formulated to such features and/or combinations of such features during the prosecution of the present application or of any further application derived therefrom.

**Claims**

1. A method of manufacturing an electronic device comprising crystalline cadmium mercury telluride which is grown on a substrate by deposition from a vapour phase, characterised in that the substrate comprises a silicon layer upon a sapphire base and in that the method comprises the steps of applying over the silicon layer a first mask having a window which includes the desired site of the cadmium mercury telluride device, etching through the silicon layer at the window to expose the sapphire base, growing at least one layer of the cadmium mercury telluride over the substrate, applying a second mask over the cadmium mercury telluride at the desired site, etching away the cadmium mercury telluride except at the desired site where protected by the second mask, exposing at least part of the cadmium mercury telluride grown on the sapphire base at the desired site, and providing at least one electrically conducting connection to the exposed cadmium mercury telluride.

2. A method as claimed in claim 1 characterised by the steps of constructing an electronic circuit on the silicon layer before the first mask is applied, exposing a connection area of the circuit by removing at least part of the first mask after growing and etching the cadmium mercury telluride and then providing a conducting connection between the exposed cadmium mercury telluride and the exposed connection area of the electronic circuit.

3. A method as claimed in claim 1 or claim 2 characterised in that, after exposing the sapphire base in the window but before growing the cadmium mercury telluride, a buffer layer of cadmium telluride is grown over the substrate, and then the cadmium mercury telluride is grown over the cadmium telluride layer.

4. A method as claimed in claim 3, characterised in that a lower cadmium mercury telluride layer is selectively retained in an area where an upper layer of cadmium mercury telluride is etched away, and the lower layer is metallised in that area to form a second conducting connection to the cadmium mercury telluride device.

5. An electronic device comprising crystalline cadmium mercury telluride grown on a substrate, characterised in that the substrate comprises a silicon layer upon part of a sapphire base, in that the cadmium mercury telluride is deposited on the sapphire base in a window in the silicon layer, and in that an electrically conducting connection is present from an area of the silicon layer to the cadmium mercury telluride device.

6. An electronic device as claimed in claim 5 characterised in that an electronic circuit is provided on the silicon layer, and in that at least one conducting connection is provided between the cadmium mercury telluride and the electronic circuit.

7. An electronic device as claimed in claim 6 or a method as claimed in Claim 2, characterised in that the device comprises on the sapphire base a linear array of cadmium mercury telluride infrared detectors connected one each to a linear array of electronic circuits.

8. An electronic device as claimed in claim 6 or a method as claimed in Claim 2, characterised in that the device comprises a two-dimensional array of cadmium mercury telluride infrared detectors arranged in rows between rows of circuits, circuits of each circuit row being connected one each with a detector in an adjacent detector row.

9. An electronic device or method as claimed in claim 7 or claim 8, characterised in that there is provided a lower cadmium mercury telluride layer which extends also between adjacent detectors and which is metallised at least in one area to provide a common connection to the detectors.

10. An electronic device as claimed in anyone of claims 6 to 9, characterised in that a buffer layer of cadmium telluride is provided between the sapphire base and the cadmium mercury telluride in the window.

Fig.1

Fig.2

Fig.3

Fig.4

Fig.5

Fig.6

Fig.7

Fig.8

EP 0 343 738 A2

Fig.9

Fig.10

Fig.11

2-Ⅲ-PHB 33463

# Fig.12

# Fig.13